# EUROPEAN PATENT APPLICATION

(11) **EP 2 378 550 A1**
(43) Date of publication of application: **19.10.2011**
(21) Application number: 10159859.7
(22) Date of filing: 14.04.2010
(51) Int. Cl.: H01L 23/31, H01L 21/56

(54) **Leadless IC package and manufacturing method thereof**

(71) Applicant: NXP B.V., 5656 AG Eindhoven (NL)
(72) Inventor: De Samber, Marc Andre, Redhill, Surrey RH1 1DL (GB); Van Grunsven, Eric Cornelis Egbertus, Redhill, Surrey RH1 1DL (GB)
(74) Representative: Williamson, Paul Lewis

(57) **Abstract**

An integrated circuit package comprises an integrated circuit (14), a package around the integrated circuit and a connection face with connection pads (18) coupled to the integrated circuit. A solder resist layer (10) has contact openings and a metal layer (12) extends over the solder resist layer and into the openings. The integrated circuit (14) is on top of the metal layer connected to portions of the metal layer which are on top of the resist layer. The base of the package comprises a planar surface comprising portions of the lower surface of the solder resist layer (10) and portions (18) of the lower surface of the metal layer (12) in the openings defining the connection pads.

The solder resist layer is applied during the foil fabrication, so that the problem of having to apply a solder resist after packaging is prevented.

## Description

This invention relates to chip packages, in particular packages which provide leadless contact terminals which are connected to an integrated circuit by a fan out arrangement.

This type of package has an arrangement of contact pads which make contact to terminals of the IC. The connection between the contact pads and the IC terminals is made by conductor lines embedded in the package.

For cost reasons and for supply chain reasons, there is a growing interest in moving towards packages with a single metal layer. The single metal layer then has to serve the purpose of providing the external contact pads to the package (die pads) at the connection surface of the package, providing bonding pads for the IC (for wire bonding of the IC or flip chip attachment) and providing fan-out between the contact pads and the IC bonding pads.

This fan-out poses a problem as the metal lines are typically exposed at the bottom side of the package, which is not acceptable. Typically this is solved by applying an additional solder resist layer to cover the metal line tracks. In one process, metal tracks are formed on a temporary carrier, which is removed at the end of the process. The solder resist layer to cover the metal tracks can then be applied after the temporary carrier removal process. However this results in recessed contact pads so that additional processing is required to enable contact to the contact pads.

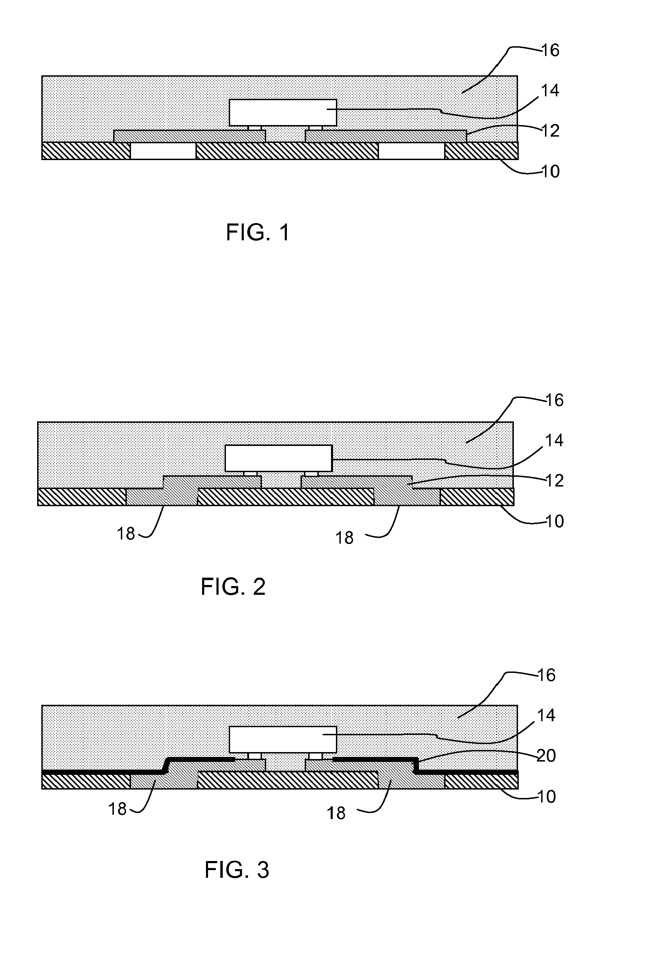

Figure 1 shows a known package design.

The structure comprises a solder resist layer 10 beneath the fan out metal layer 12. The IC 14 sits on top of the fan out metal layer 12 and is encapsulated by layer 16. The metal layer 12 is formed on a temporary substrate (not shown), and only after removal of the temporary substrate is the solder resist layer 10 applied.

The IC pads are generally termed the "first level" connections and the package connection pads are generally termed the "second level" connections.

Thus, the solder resist layer needs to be applied after assembly, and the second level pads are recessed in openings in the solder resist layer.

There is therefore a need for an improved process which also enables a single metal layer to be used.

According to the invention, there is provided a method of forming an integrated circuit package comprising an integrated circuit, a package around the integrated circuit and a connection face with connection pads coupled to the integrated circuit, the method comprising:
depositing and patterning a solder resist layer on a temporary substrate, the patterning defining contact openings to the underlying temporary substrate;
depositing and patterning a metal layer, which extends into the openings and on top of the resist layer;
connecting an integrated circuit to portions of the patterned metal layer which are on top of the resist layer;
performing an overmoulding process; and
releasing the temporary substrate to reveal the connection face which comprises a planar surface with solder resist portions and metal portions.

By applying a solder resist layer during the foil fabrication, the problem of having to apply a solder resist after packaging is prevented. This means that no photolithography process is required in the assembly line.

The temporary substrate can comprise aluminium.

The metal layer typically comprises copper with suitable finishing layers. A top finishing layer is designed for the die attach process, and a bottom finishing layer is designed for soldering. For example the metal layer can comprise copper and nickel and gold, or copper and nickel and palladium and gold. Many known metal stack structures can be used, for example which are known for flip chip bonding. The metal layers are deposited and patterned by a resist and etch process. The metal layer can be treated to define solder pads for the connections to the integrated circuit.

The integrated circuit can be connected by flip chip bonding or by die attach and wire bonding.

The structure can be separated into separate packages at the end of the process.

The invention also provides an integrated circuit package comprising an integrated circuit, a package around the integrated circuit and a connection face with connection pads coupled to the integrated circuit, comprising:
a solder resist layer having contact openings;
a metal layer which extends over the solder resist layer and into the openings;
an integrated circuit on top of the metal layer connected to portions of the metal layer which are on top of the solder resist layer;
an overmoulding over the integrated circuit;
wherein the base of the package comprises a planar surface comprising portions of the lower surface of the solder resist layer and portions of the lower surface of the metal layer in the openings defining the connection pads.

Examples of the invention will now be described in detail with reference to the accompanying drawings, in which:
Figure 1 shows a known integrated circuit package;
Figure 2 shows a first example of integrated circuit package of the invention;
Figure 3 shows a second example of integrated circuit package of the invention;
Figure 4 shows an example of process flow; and
Figure 5 shows a third example of integrated circuit package of the invention.

The invention provides a method of forming an integrated circuit package in which a solder resist layer is first deposited and patterned on a temporary substrate, the patterning defining contact openings to the underlying temporary substrate. A metal layer extends into the openings and on top of the resist layer, so that it defines contact areas for the IC in one plane and defines a contact surface in another plane.

Figure 2 shows a first example of integrated circuit package of the invention.

The integrated circuit 14 is again surrounded by a resin package 16 around the integrated circuit. The single metal layer 12 provides fan out from the IC pins to contact pads 18 provided on a lower connection face.

The solder resist layer 12 has contact openings, and the metal layer 12 extends over the solder resist layer 12 and into the openings to define the connection pads 18. The IC is connected to portions of the metal layer 12 which are on top of the resist layer 10. The base of the package thus comprises a planar surface comprising portions of the lower surface of the solder resist layer 10 and portions of the lower surface of the metal layer in the openings defining the connection pads 18.

Figure 3 shows a second example of integrated circuit package of the invention. Compared to Figure 2, an additional solder resist layer 20 is added to assist with a flip chip process used to attach the lC 14, by limiting wetting.

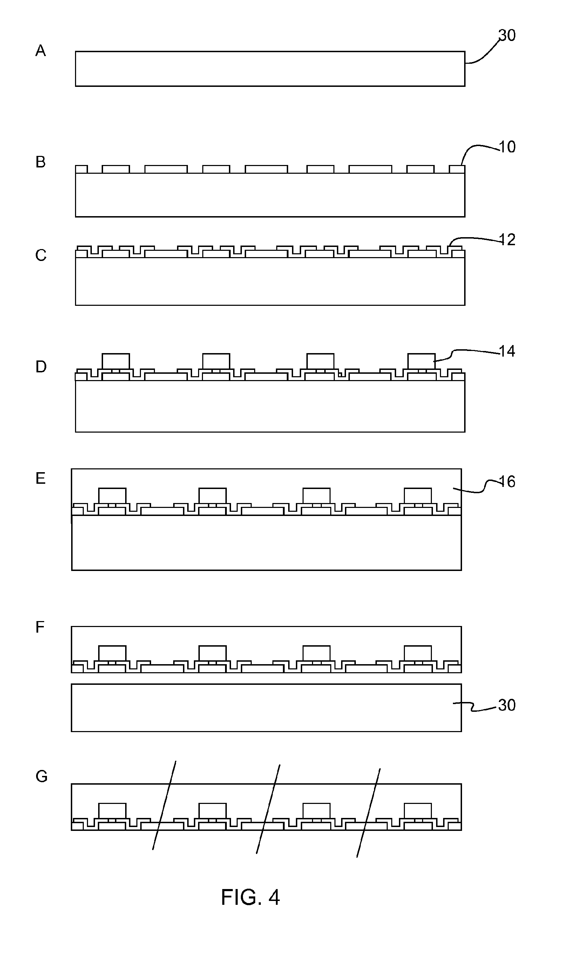

Figure 4 shows an example of process flow for forming the package of the invention.

The example is for a flip chip die attach configuration, although the concept is also applicable to wire bonded products.

Figure 4A shows a temporary substrate 30 in the form of metal carrier or organic carrier, for example be an aluminium foil.

Figure 4B shows a solder resist layer 10 which has been applied and patterned. The gaps in the pattern will define the contact pads at the bottom of the package, and the solder resist portions will define the base of the package between the contact pads.

Figure 4C shows the application of the metal pattern 12 for example using an additive process of plating Cu on a plating base layer (e.g. Au and/or Pd and/or Ni) using a photoresist. Thus, an additive copper plating process can be used.

The top side of the Cu layer can be provided with an appropriate finish layer if needed, depending on the flip chip process to be used. For example the finish layer can be nickel and palladium and gold, or copper and silver or copper and nickel and gold. Many other combinations of metals will be known to those skilled in the art.

Also, the additional solder resist layer 20 shown in Figure 3 can be applied as a confinement layer for the flip chip process.

Figure 4D shows the lCs 14 attached by a die attach process such as flip chip bonding.

Figure 4E shows the over moulding layer 16.

Figure 4F shows the temporary carrier substrate 30 removed for example by peeling or etching. The connection pads can be treated if desired.

Figure 4G shows separation into individual packages.

In this method, the pre-applied solder resist layer provides the second level pad confinement. This is part of the package manufacture process and does not need to be implemented in the back end process. The second level pads are also no longer recessed. Thus, various improvements in the process flow are provided.

The fan out is implemented simply by patterning the metal layer and, if desired, crossing lines can be implemented by using additional layers.

The metal layer is copper in the example above, but it may instead be aluminium. This can be sputter deposited. The finishing of the aluminium layer to form the solder areas for the IC can comprise an electroless Ni/Au process (zincate). This is an electroless metallization processes based on mechanical seeding.

The flip chip method can be replaced with a wirebonding method without changing the underlying concept of the invention.

The IC is formed with solder pads for connection to the metal layer by the flip chip process. The lC is conventional and has not been described in detail. It may typically comprise aluminium contact pads, which have been processed with the zincate processing method to from a Zn layer, on top of which a Ni/Au contact is formed. The solder can be applied to the Ni/Au contact by solder printing and reflow. Alternatively, preformed solder balls can be applied to give the desired space under the die.

In example above, a solid temporary carrier substrate is used, and it is removed and discarded at the end of the process. A re-usable temporary substrate can also be used. In this case, a perforated carrier can be used with sacrificial etch holes, for example a glass or silicon substrate. This is covered with a sacrificial layer, for example a laminated foil layer for example aluminium. The temporary carrier can then be removed at the end of the process by sacrificial etching of the aluminium layer to release the re-usable carrier.

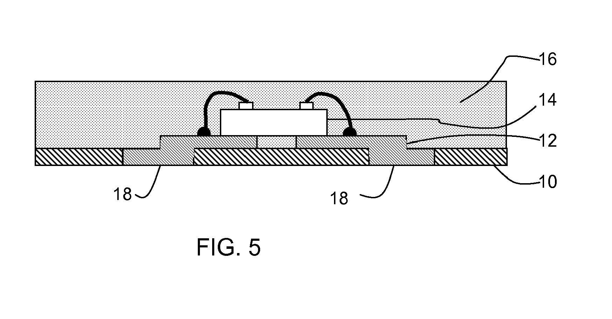

As mentioned above, the chip can be applied by a die attach and wire bonding process, and the resulting structure is shown in Figure 5.

The invention is of particular interest for applications with large numbers of I/O terminals.

Various modifications will be apparent to those skilled in the art.

## Claims

1. A method of forming an integrated circuit package comprising an integrated circuit (14), a package around the integrated circuit and a connection face with connection pads (18) coupled to the integrated circuit (14), the method comprising:
depositing and patterning a solder resist layer (10) on a temporary substrate (30), the patterning defining contact openings to the underlying temporary substrate (30);
depositing and patterning a metal layer (12), which extends into the openings and on top of the resist layer (10);
connecting an integrated circuit (14) to portions of the patterned metal layer which are on top of the resist layer;
performing an overmoulding process; and
releasing the temporary substrate (30) to reveal the connection face which comprises a planar surface with solder resist portions (10) and metal portions (18).

2. A method as claimed in claim 1, wherein the temporary substrate (30) comprises aluminium.

3. A method as claimed in claim 2, wherein the temporary substrate comprises aluminium on top of a carrier plate which has etch openings for the etching of the aluminium.

4. A method as claimed in any preceding claim, wherein the metal layer (12) comprises copper.

5. A method as claimed in any preceding claim, wherein the metal layer (12) comprises copper and one or more finishing layers.

6. A method as claimed in any preceding claim, wherein depositing and patterning a metal layer (12) comprises a resist and etch process.

7. A method as claimed in any preceding claim, comprising treating the metal layer to define solder pads.

8. A method as claimed in any preceding claim, wherein connecting the integrated circuit (14) comprises flip chip bonding or die attach and wirebonding.

9. A method as claimed in any preceding claim, further comprising separating the structure into separate packages.

10. An integrated circuit package comprising an integrated circuit (14), a package around the integrated circuit and a connection face with connection pads (18) coupled to the integrated circuit, comprising:
a solder resist layer (10) having contact openings;
a metal layer (12) which extends over the solder resist layer and into the openings;
an integrated circuit (14) on top of the metal layer connected to portions of the metal layer which are on top of the resist layer;
an overmoulding (16) over the integrated circuit;
wherein the base of the package comprises a planar surface comprising portions of the lower surface of the solder resist layer (10) and portions (18) of the lower surface of the metal layer (12) in the openings defining the connection pads.

11. A package as claimed in claim 9, wherein the metal layer (12) comprises copper.

12. A package as claimed in claim 10 or 11, wherein the metal layer comprises copper and one or more finishing layers.

13. A package as claimed in any one of claims 10 to 12, wherein the top of the metal layer has a finishing layer defining contact areas to the integrated circuit.

14. A package as claimed in any one of claims 10 to 13, wherein the integrated circuit comprises a flip chip bonded or wirebonded integrated circuit.
